# EUROPEAN PATENT APPLICATION

(11) **EP 0 810 700 A2**
(43) Date of publication of application: **03.12.1997**
(21) Application number: 97302983.8
(22) Date of filing: 01.05.1997
(51) Int. Cl.: H01S 3/096, H05B 33/08

(54) **On-chip high frequency damping for driver chips**

(30) Priority: 03.05.1996 US 642815
(71) Applicant: XEROX CORPORATION, Rochester New York 14644 (US)
(72) Inventor: Buhler, Steven A., Sunnyvale, California 94087 (US); Bahramian, Hamid T., Torrance, California 90501 (US)
(74) Representative: Reynolds, Julian David

(57) **Abstract**

A driver chip (14) for a laser diode (10) is disclosed which has a circuit to substantially reduce a ringing (Fig. 3) on a laser diode driving current generated by the driver chip. This invention is based on the discovery that the ringing on the laser diode driving current is caused by three different resonances which are coupled together. One or more series RC damping circuits (R₁, C₃) are fabricated between the main nodes (O, G) of the driver (14) to substantially reduce the ringing on the laser diode driving current.

## Description

This invention relates to driver circuits for electronic devices, and more particularly to such circuits including damping elements for reducing unwanted ringing following transitions between two signal levels.

The invention finds applications, for example, in driver circuits for laser diodes.

The preferred embodiment of this invention is designed for a laser diode driver chip which provides a driving current to a visible laser diode. However, the disclosed embodiment of this invention can be utilized for laser diode drivers which provide current to other types of laser diodes. For the purpose of simplicity hereinafter, the "visible laser diode" will be referred to as "laser diode"

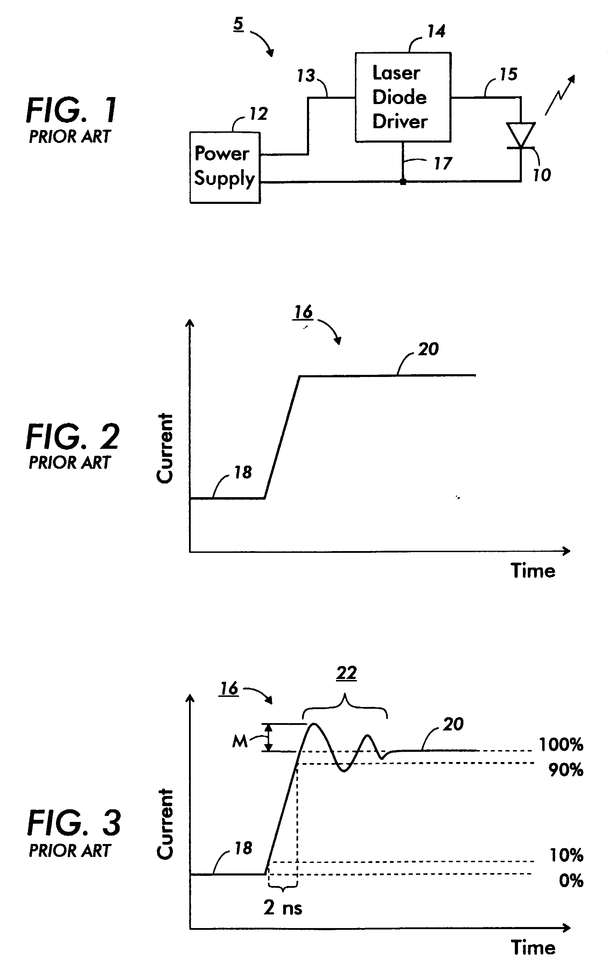

Referring to Figure 1, there is shown a block diagram of a circuit 5 for an application of a known laser diode driver. Typically a laser diode 10 is connected to a power supply 12 through a laser diode driver chip 14. The power supply is connected to the laser diode driver chip 14 through a lead line 13 and the laser diode driver chip 14 is connected to the laser diode 10 through a lead line 15. The ground of the laser diode 10 is connected to the ground of the laser diode driver chip 14 and to the ground of the power supply 12 as shown by a lead line 17.

The reason the laser diode 10 is powered through a laser diode driver chip 14 is that the laser diode driver chip 14 is a controller chip. The laser diode driver chip 14 drives the laser diode 10 to an emitting state and to a non-emitting state by supplying a two level laser driving current to the laser diode. For the purpose of simplicity, hereinafter the "laser diode driver chip" will be referred to as "driver chip".

Referring to Figure 2, there is shown a two level laser driving current 16 at its ideal format. Referring to both Figures 1 and 2, the driver chip 14 generates a two level current 16 based on a controlling signal such as a train of pixel information. The laser diode 10 is driven to a non-emitting state if it receives the level 18 of the current 16 and it starts emitting if it receives the level 20 of the current 16.

Typically, when the driver chip 14 switches the current from level 18 to level 20, the current 16 starts ringing. Referring to Figure 3, there is shown the two level current 16 of Figure 2 in a real situation. Figure 3, shows a ringing 22 on current 16 when the current is switched from level 18 to level 20. The ringing of the current 16 is based on an oscillation caused by an unknown factor in the block diagram 5 of Figure 1.

A problem is that the ringing 22 of the current 16 reduces the life time of the laser diode 10 and if the laser diode is used in a printing system, the ringing of the current 22 also reduces the print quality. Therefore, it is desirable to damp the ringing of the current 16 in order to prolong the life time of the laser diode 10 and improve the print quality. However, since it is not known what exactly causes the oscillation in the circuit 5, it is difficult to damp the ringing 22 of the current 16.

It is an object of this invention to damp the ringing 22 in the laser driving current 16 to less than a certain proportion, such as 20%, of the maximum M of its first peak while keeping the rise time of the current 16 within a maximum time, such as 2 ns. Considering level 18 (non-emitting state) of current 16 as 0% and level 20 (emitting state) of current 16 as 100%, the rise time of the current 16 as shown in Figure 3 is defined by the time between the 10% and 90 % of current 16.

In accordance with the present invention, there is provided a driver circuit for driving a device with a signal varying, in use, between two or more discrete levels comprising: an input node for connection to a power supply, an output node for connection to the device, a ground node, a first capacitor and a first resistor, the first capacitor and the first resistor being connected in series between said output node and said ground node, thereby reducing ringing of said signal following transition between two of said levels.

The invention employs a model to identify the source of a ringing problem on a laser diode driving current generated by a laser diode driver chip and there is disclosed a solution to the ringing problem. This invention recognizes that the ringing is caused by three different resonances which are coupled, provides a model which represents the three different sources of the resonances and identifies the common nodes between the sources of the resonances. The common nodes between the sources are V_{DD} (the voltage receiving node of the chip), the output node and the chip ground. By placing individual RC (a resistor and a capacitor in series) circuits across these three nodes, each resonance is individually damped. As a result, the ringing problem on the laser diode driving current is also damped.
Figure 1 shows a block diagram of a circuit for an application of a laser diode driver according to the prior art;
Figure 2 shows a two level laser driving current at its ideal format for the circuit of Fig. 1;
Figure 3 shows the two level current of Figure 2 in a real situation;
Figure 4 shows a model for the circuit of Figure 1;
Figure 5 shows a damping circuit consisting of an RC circuit being placed in parallel with the capacitance C₁ of Figure 4;
Figure 6 shows the damping circuit of Figure 5 being added to the circuit of Figure 1;
Figure 7 shows a different model for the circuit of Figure 1;
Figure 8 shows the model of Figure 7 with an additional capacitor C₅ which modifies the frequency of one of the resonances of the model of Figure 7;
Figure 9 shows the model of Figure 8 with the addition of a damping circuit;
Figure 10 shows the damping circuit of Figure 9 being added to the circuit of Figure 1;
Figure 11 shows a preferred embodiment of a model for the circuit of Figure 1;
Figure 12 shows the model of Figure 11 with the addition of a parasitic capacitance C₅ between V_{DD} and the output node O;
Figure 13 shows the circuit of Fig. 12 with the addition of a damping circuit in a preferred embodiment of the invention; and
Figure 14 shows the damping circuit of Figure 13 being placed on the driver chip 14 of Figure 1.

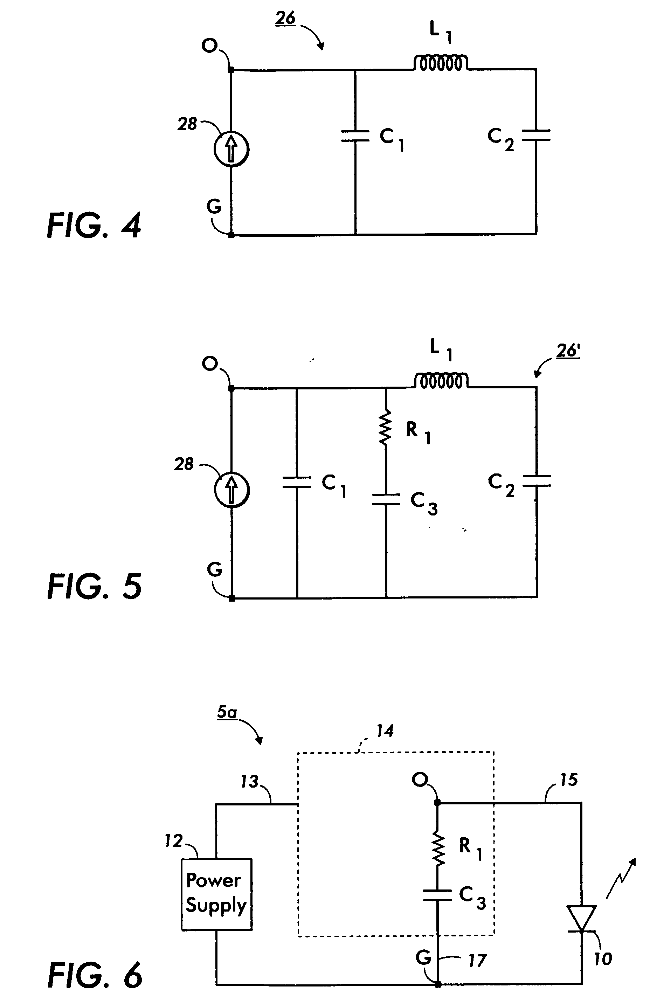

Referring to Figure 4, there is shown a model 26 of the portion of the circuit 5 of Figure 1 which causes the oscillation. Here it is assumed that the portion in which the oscillation is generated is a loop which consists of the output of the driver chip 14 of Figure 1 and the laser diode 10 of Figure 1. In Figure 4, the suggested model for the output of the driver chip 14 of Figure 1 is a current source 28 and a capacitance C₁ which are considered to be located between the output node O of the driver chip and the chip ground G of the output driver chip. The output node O is a node which is in control of the laser diode driving current and the chip ground G is an internal ground to the packaged laser diode driver chip 14. Also, the suggested model for the laser diode 10 of Figure 1 is a capacitance C₂ and the suggested model for the lead connection 15 between the driver chip 14 and the laser diode 10 of Figure 1 is an inductance L₁. Inductance L₁ includes the inductance of the bond wires of the driver chip 14 and the laser diode 10 in addition to the inductance of the lead connection between the driver chip 14 and the laser diode 10.

By studying this model 26, it is determined that since the capacitance C₂ representing the laser diode 10 is a large capacitance, when the laser diode is in the emitting state (forward bias), the capacitance C₂ will act as a short. As a result, the oscillation should be caused by the capacitance C₁ and the inductance L₁.

Referring to Figure 5, there is shown model 26' which is the same as model 26 except for the addition of the damping circuit. In Figure 5, to damp the oscillation caused by the capacitance C₁ and the inductance L₁, an RC (a resistor and a capacitor in series) damping circuit consisting of resistor R₁ and capacitor C₃ is placed in parallel with the capacitance C₁ on the driver chip 14 of Figure 1.

In Figure 5, the added RC circuit causes both series resonance and parallel resonance. In parallel resonance, the original capacitance C₁ and the inductance L₁ which cause the resonance are in parallel with resistor R₁. In series resonance, the added capacitor C₃ and the inductance L₁ which cause the resonance are in series with resistor R₁.

It should be noted that in this specification, the terms "capacitance" and "inductance" represent modeled elements. However, the terms "capacitor" and "resistor" represent actual elements of the damping circuit.

In order to damp a series resonance, a resistor with a higher resistance should be selected. However, for damping a parallel resonance, a resistor with a very low resistance is required. Therefore, since in Figure 5 both series resonance and parallel resonance exists, resistor R₁ has to be selected in such a manner to have a resistance which is not too high and not too low in order to damp both kinds of resonances. The value of the resistor R₁ is also dependent on the value of the inductance L₁ and the capacitor C₁.

Once the values of the resistor R₁ and the capacitor C₃ are determined, they can be included on the driver chip 14 of Figure 1 during fabrication. Referring to Figure 6, there is shown R₁ and C₃ when added to the driver chip 14 of Figure 1. R₁ and C₃ are placed on the chip between the output node O and the chip ground G. The reason R₁ and C₃ are placed on the chip is to prevent adding extra lead inductances which would be added if they were placed outside of the chip.

Once the resistor R₁ and the capacitor C₃ are placed on the chip, the ringing on the laser diode driving current is reduced.

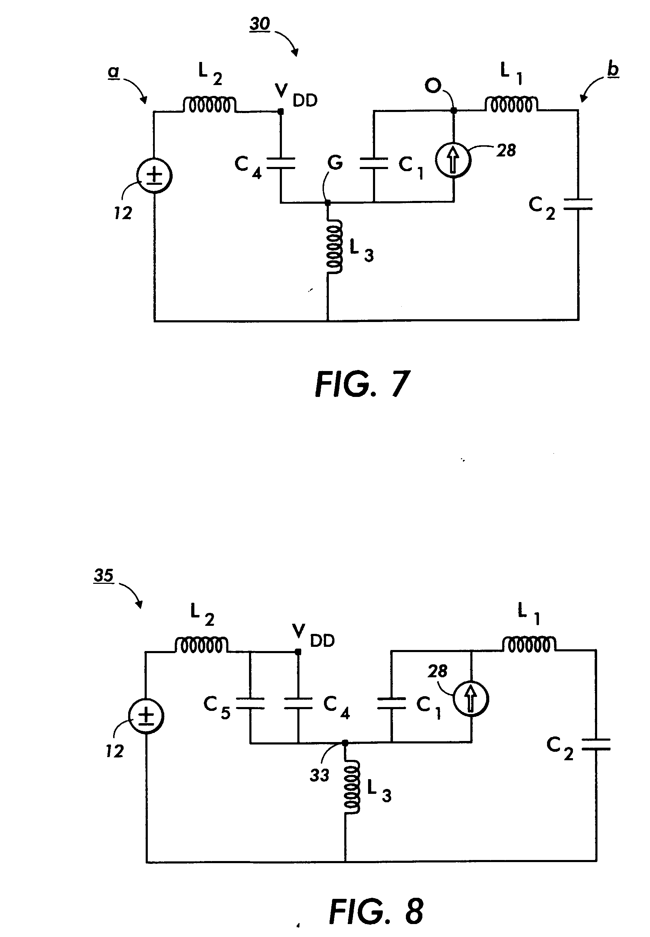

Referring to Figure 7, there is shown a suggested alternative model 30 of the circuit of Fig. 1. It is found that this model can be used in order to design a more effective damping circuit than the model 26 of Figure 4. In Figure 7, the power supply 12 of Figure 1 is shown by the symbol 12 of a power supply. The power supply 12 of Figure 1 has a decoupling capacitor which is typically mounted next to the packaged driver chip 14 of Figure 1. The decoupling capacitance of the power supply 12 is a large capacitance and does not contribute to the oscillation. Therefore for the purpose of simplicity, in the model of Figure 7 and the models of the following Figures, the decoupling capacitance of the power supply 12 of Figure 1 is not shown.

Again referring to Figure 7, the laser diode 10 of Figure 1 is modeled as capacitance C₂. In this approach, the driver chip 14 of Figure 1 is modeled as a capacitance C₁, current source 28 and capacitance C₄. Capacitance C₁ and the current source 28 are considered to be located between the output node O and the chip ground G and capacitor C₄ is considered to be located between V_{DD} and the chip ground G. V_{DD} is the voltage receiving node of the chip and it has a voltage substantially the same as the voltage of the power supply 12.

Referring to both Figures 1 and 7, it is suggested that the lead line 15 shared by the driver chip 14 and the laser diode 10 has an inductance shown by L₁. Also, it is suggested that the lead line 13 shared by the power supply 12 and the driver chip 14 has an inductance shown by L₂. In addition, it is suggested that the lead line 36 which is the ground line of the driver chip has an inductance shown by L₃.

Inductance L₃ couples the resonances of loop a and loop b in Fig. 7. Loop a consists of inductance L₂, capacitance C₄, inductance L₃ and the power supply 12. Loop b consists of inductance L₁, capacitance C₂, inductance L₃ and capacitance C₁. As a result, when any one of the inductances L₁ and L₂ is stimulated by the change of the level on the laser driving current 16 (Figure 3), both inductances L₁ and L₂ and their respective capacitance C₁ and C₄ start resonating. However, the resonance of each inductance is at a different frequency and they are coupled with each other. Therefore, every time the driver chip 14 is switched, both inductances L₁ and L₂ with their respective capacitances C₁ and C₄ resonate.

In order to damp each resonance separately, it is needed to change and separate the two frequencies of the resonances from each other as much as possible. Therefore, it is needed to add an additional capacitor to the driver chip in order to change the frequency of the resonance generated by the inductance L₂ and C₄. It should be noted that changing one of the frequencies does not change the coupling between the two resonances.

Referring to Figure 8, there is shown the additional capacitor C₅ which causes the frequency of resonance generated by the inductance L₂ and C₄ to substantially differ from the frequency of resonance generated by the inductance L₁ and the capacitance C₁.

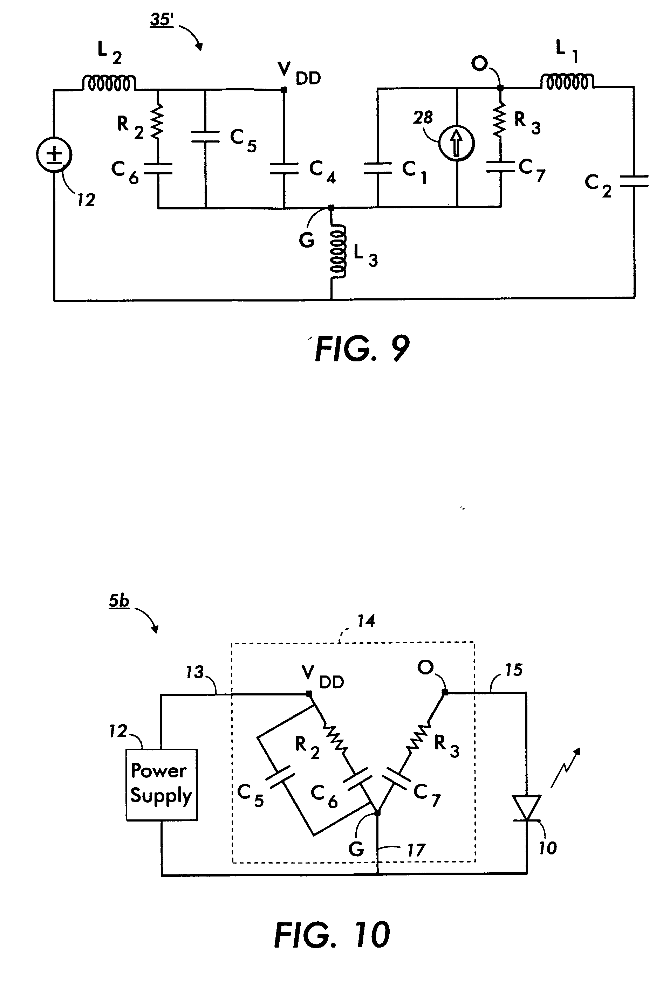

Referring to Figure 9, there is shown model 35' which is the same as model 35 except for the addition of a damping circuit. In Figure 9, in order to damp each resonance separately, an RC damping circuit is suggested for each resonance. Resistor R₂ and capacitor C₆ are connected in parallel to capacitance C₄ and capacitor C₅ to damp the resonance generated by the inductance L₂ and the combination of the capacitance C₄ and capacitor C₅. Also, resistor R₃ and the capacitor C₇ are connected in parallel to the current source 28 to damp the resonance generated by the inductance L₁ and the capacitance C₁.

Once the values of the resistor R₂, capacitor C₆, resistor R₃ and capacitor C₇ are determined, they can be included on the driver chip 14 of Figure 1 during fabrication. Referring to Figure 10, there is shown R₂, C₆, R₃ and C₇ when added to the driver chip 14 of Figure 1. Resistor R₂ and capacitor C₆ are placed on the chip between V_{DD} and the chip ground G and resistor R₃ and capacitance C₇ are placed between the output node O and the chip ground G. Again the reason resistor R₂, capacitor C₆, resistor R₃ and capacitor C₇ are placed on the chip is to prevent adding extra lead inductances. Also, since capacitor C₅ was an additional capacitance which was placed on the model 35 of Figure 8, it has to be added to the driver chip between V_{DD} and the chip ground G in parallel to resistor R₂ and capacitor C₆.

After the resistor R₂, the capacitor C₆, the resistor R₃ and the capacitor C₇ are placed on the chip, the ringing on the laser diode driving current is reduced more than the aforementioned approach.

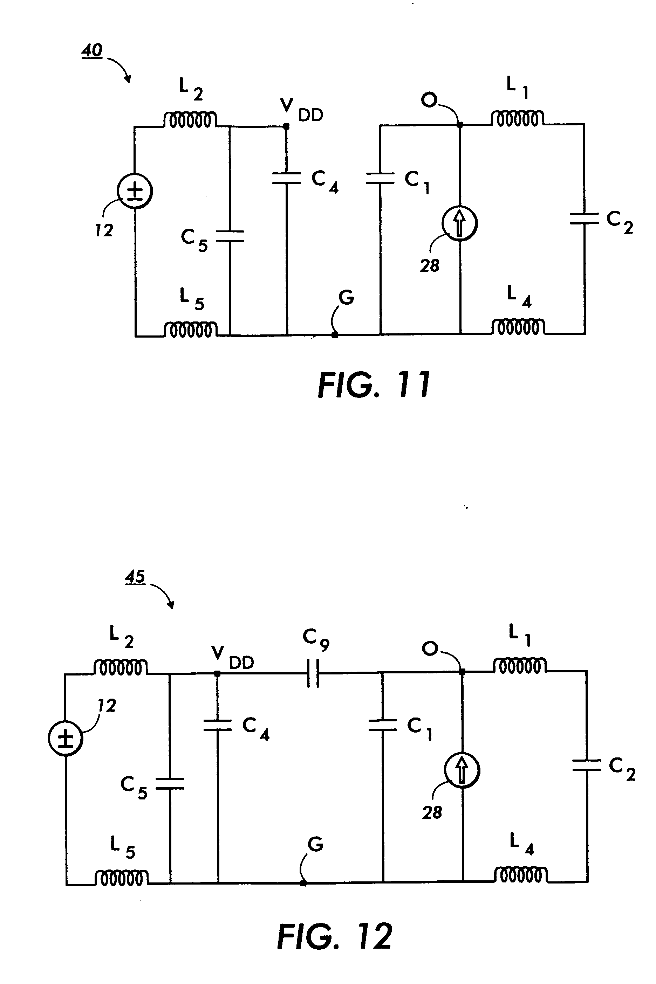

Referring to Figure 11, there is shown yet another model 40 to eliminate the ringing problem of the laser diode driving current. It is found that this model can be used in order to design a more effective damping circuit than the model 35 of Figure 8. In this approach, the laser diode 10 of Figure 1 is modeled as capacitance C₂. Also, the driver chip 14 of Figure 1 is modeled as a capacitance C₁, current supply 28 and capacitance C₄. Capacitance C₁ and the current source 28 are considered to be located between the output node O and the chip ground G and capacitor C₄ is considered to be located between V_{DD} and the chip ground G. The additional capacitance C₅ of Figure 8 is also included in the model 40 of Figure 11 between V_{DD} and the chip ground G.

Referring to both Figures 1 and 11, it is suggested that the ground lead of the power supply 12 is a separate ground lead than the ground lead of the laser diode 10 as opposed to one common ground lead used in Figure 8. As a result, the inductance L₃ of Figure 8 is eliminated and two inductances L₄ and L₅ are placed in model 40 to represent the connection between the laser diode 10 and the driver chip 14 and the connection between the power supply 12 and the laser diode chip 14 respectively.

After separating the ground leads for the laser diode 10 and the power supply 12, eliminating the inductance L₃ of Figure 8 and placing the solution on the driver chip, it was observed that the oscillations were still coupled. This indicated that there is a parasitic capacitance between the V_{DD} and the output node O of the driver chip 14 of Figure 1.

Referring to Figure 12, there is shown model 45 which is model 40 of Figure 11 with the addition of the parasitic capacitance C₉ between V_{DD} and the output node O. In this model 45, the inductances L₅ and L₂ and the combination of the capacitance C₄ and the capacitor C₅ generate one resonance mode, inductances L₁ and L₄ and the capacitance C₁ generate a different resonance mode and the combination of the inductances L₁ and L₂ and the capacitance C₉ generate yet a third resonance mode.

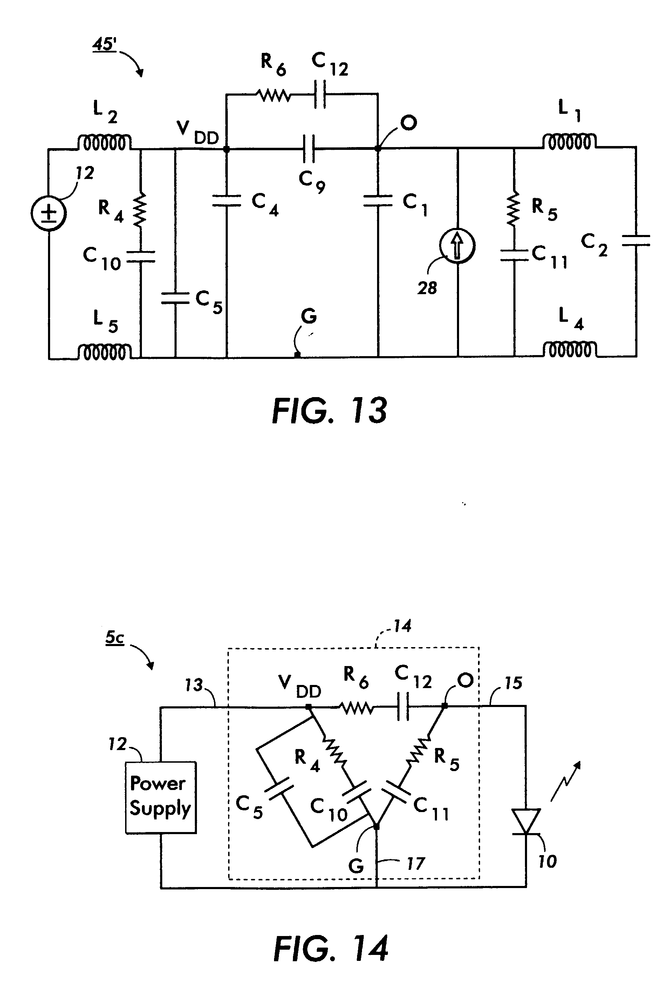

Referring to Figure 13, there is shown model 45' which is the same as model 45 except for the addition of a damping circuit. In Figure 13, in order to damp each resonance, a separate RC damping circuit is placed in parallel to each one of the capacitances C₁ and C₉ and an RC circuit is placed in parallel to capacitance C₄ and capacitor C₅. Resistor R₄ and the capacitor C₁₀ are placed in parallel to capacitance C₄ and capacitor C₅, resistor R₅ and the capacitor C₁ are placed in parallel to the capacitance C₁ and the resistor R₆ and the capacitance C₁₂ are placed in parallel to the capacitance C₉.

Once the values of the resistor R_{4,} capacitor C₁₀ , resistor R₅, capacitor C₁₁, resistor R₆ and capacitor C₁₂ are determined, they are included on the driver chip 14 of Figure 1 during fabrication.

Referring to Figure 14, there is shown R₄, C₁₀, R₅, C₁₁, R₆ and C₁₂ when added to the driver chip 14 of Figure 1. Resistor R₄ and capacitor C₁₀ are formed on the chip between V_{DD} and the chip ground G, resistor R₅ and capacitance C₁₁ are formed between the output node O and the chip ground G and resistor R₆ and capacitor C₁₂ are formed between V_{DD} and the output node O. Again the reason resistor R₄, capacitor C₁₀, resistor R₅, capacitor C₁₁, resistor R₆ and capacitor C₁₂ are placed on the chip is to prevent adding extra lead inductances. Also, since capacitor C₅ is an additional capacitance which was placed on the models 40 and 45 of Figures 11 and 12, it has to be added to the driver chip between V_{DD} and the chip ground G in parallel to resistor R₂ and capacitor C₆.

The circuit shown in Figure 14, sufficiently reduced the ringing problem of the laser diode driving current 16 of Figure 3 to under 20% of its first peak while keeping the rise time of the laser diode driving current 16 of Figure 3 within 2 ns. Reducing the ringing problem prolongs the lifetime of the laser diode 10 and improves the print quality.

The preferred embodiment of the driver chip of this invention utilizes BiCMOS technology. Also, in the preferred embodiment of this invention, the laser diode is a common cathode laser diode which requires a high speed switching. Due to the required high speed switching, the driver chip utilizes large PNP transistors as its output current source.

Since all the added RC damping circuits of Figures 5, 9 and 13 have to be placed on the driver chip 14, the capacitors of the RC circuits have to be optimized for the limited real estate available on the driver chip. The capacitors used in the RC circuits of the preferred embodiment of this invention are bipolar and linear. Typically, in order to eliminate the parasitic capacitances of the bipolar capacitors, each capacitor requires a large gate oxide. Therefore, the sizes of the capacitors are optimized for eliminating the ringing problem and reducing the area used for gate oxide. The total capacitances used in the RC circuits to eliminate the ringing problem are between 250 to 300 pF. This circuit is capable of reducing the ringing of the laser diode driving current with a frequency between 30 - 300 MHz.

It should be noted that any technology can be used in place of the BiCMOS technology of this invention. However, for each technology, the values of the RC circuits have to be modified.

It should also be noted that the driver chip with the damping circuit of this invention can also be utilizes in conjunction with more complex laser diode packages such as multidiodes on a common substrate tightly packed packages.

It should further be noted that the sizes of the capacitors and the resistors will be selected based on the resonance frequencies of each given system.

## Claims

1. A driver circuit (14) for driving a device (10) with a signal varying, in use, between two or more discrete levels (18,20) comprising:
an input mode (V_{DD}) for connection to a power supply,
an output mode (O) for connection to the device,
a ground mode (G),
a first capacitor (C₃) and a first resistor (R₁), the first capacitor and the first resistor being connected in series between said output mode (O) and said ground mode (G), thereby reducing ringing of said signal following transition between two of said levels.

2. The circuit of claim 1, further comprising:
a second resistor (R₂) and a second capacitor (C₆), said second resistor and said second capacitor being connected in series between said input node (V_{DD}) and said ground node.

3. The circuit of claim 1 or 2, further including a fourth capacitor (C₅) connected between the input node (V_{DD}) and to said ground node (G) and in parallel to said second resistor (R₂) and said second capacitor (C₆).

4. The circuit of claim 1, 2 or 3, further comprising:
a third resistor (R₆) and a third capacitor (C₁₂), said third resistor and said third capacitor being connected between said input node (V_{DD}) and said output node (O).

5. The circuit of any of claims 1 to 4, further including a fifth capacitor which is electrically connected to said input node and to said ground mode and is parallel to said first resistor and said first capacitor.

6. The circuit of any of the preceding claims when formed as an integrated circuit chip.

7. The circuit of any of the proceding claims, when adapted for driving a laser diode.
